# EUROPÄISCHE PATENTANMELDUNG

(11) **EP 4 835 492 A1**
(43) Veröffentlichungstag der Anmeldung: **04.11.2026**
(21) Anmeldenummer: 25173654.2
(22) Anmeldetag: 30.04.2025
(51) Int. Cl.: G01R 1/20, G01R 19/32

(54) **STROMMESSVORRICHTUNG FÜR EIN ELEKTRISCHES VERSORGUNGSNETZ MIT EINEM SHUNT**

(71) Anmelder: EMH metering GmbH & Co. KG, 19258 Gallin (DE)
(72) Erfinder: Hardtstock, Heiko, 21337 Lüneburg (DE)
(74) Vertreter: Hauck Patent- und Rechtsanwälte PartmbB

(57) **Zusammenfassung**

Strommessvorrichtung für ein elektrisches Versorgungsnetz, die einen Shunt und eine Verstärkerschaltung aufweist, die dazu eingerichtet ist, einen Spannungsabfall an dem Shunt zu erfassen und an einem Ausgang eine elektrische Größe zur Verfügung zu stellen, die proportional zu einem durch den Shunt fließenden Strom ist, wobei die Verstärkerschaltung eine Kombination von Widerständen aufweist, die einen Verstärkungsfaktor der Verstärkerschaltung bestimmt, wobei die relative Änderung des elektrischen Widerstands des Shunts mit der Temperatur von einem ersten Temperaturkoeffizienten beschrieben wird, wobei mindestens einer der Widerstände der Kombination von Widerständen oder eine Unterkombination der Widerstände der Kombination von Widerständen thermisch mit dem Shunt gekoppelt ist, wobei die relative Änderung des elektrischen Widerstands des mindestens einen Widerstands oder der Unterkombination der Widerstände mit der Temperatur von einem zweiten Temperaturkoeffizienten beschreiben wird, wobei eine über einen Betriebstemperaturbereich gemittelte Abweichung des zweiten Temperaturkoeffizienten von dem ersten Temperaturkoeffizienten höchstens 50 % beträgt.

## Beschreibung

Die Erfindung betrifft eine Strommessvorrichtung für ein elektrisches Versorgungsnetz. Die Strommessvorrichtung weist einen Shunt und eine Verstärkerschaltung auf, mit der ein Spannungsabfall an dem Shunt erfasst wird. An einem Ausgang stellt die Verstärkerschaltung eine elektrische Größe zur Verfügung, die proportional zu einem durch den Shunt fließenden Strom ist.

Die Proportionalität der Ausgangsgröße zu dem zu messenden, durch den Shunt fließenden Strom ist für die Genauigkeit der Messung von Bedeutung. Da die Temperatur des Shunts von den Umgebungsbedingungen abhängt und sich der Shunt zudem bei einem Stromfluss aufgrund der Verlustleistung erwärmt, wird insbesondere angestrebt, für den Shunt ein Widerstandsmaterial einzusetzen, dessen elektrischer Widerstand möglichst unabhängig von der Temperatur ist. Zudem sollte der Absolutwert des elektrischen Widerstands des Shunts klein genug sein, um auch bei großen Stromstärken eine geringe Verlustleistung zu verursachen.

Ein häufig verwendetes Material für Shunts ist eine unter dem Markennamen "Manganin" bekannte Legierung aus Kupfer, Nickel und Mangan. Derartige, spezielle Widerstandsmaterialien sind relativ teuer, einerseits wegen der speziellen Legierung, andererseits wegen der in der Regel notwendigen Kontaktierung mit zum Beispiel Kupferleitern, um ein problemlos verwendbares Bauteil zu erhalten.

Aus der Druckschrift EP 3 570 046 B1 ist eine Strommessvorrichtung mit den Merkmalen des Oberbegriffs des Anspruchs 1 bekannt geworden, die einen Temperatursensor aufweist, mit dem eine Temperatur des Shunts gemessen wird. Anhand der gemessenen Temperatur wird die aus einer Kalibrierung bekannte Temperaturabhängigkeit des elektrischen Widerstands des Shunts bei der Ermittlung von Messwerten für den Strom rechnerisch kompensiert.

Davon ausgehend ist es die Aufgabe der Erfindung, eine Strommessvorrichtung mit hoher Messgenauigkeit, einfachem und kostengünstigem Aufbau zur Verfügung zu stellen.

Diese Aufgabe wird gelöst durch die Strommessvorrichtung mit den Merkmalen des Anspruchs 1. Vorteilhafte Ausgestaltungen sind in den Unteransprüchen angegeben.

Die Strommessvorrichtung ist für ein elektrisches Versorgungsnetz bestimmt und weist einen Shunt und eine Verstärkerschaltung auf, die dazu eingerichtet ist, einen Spannungsabfall an dem Shunt zu erfassen und an einem Ausgang eine elektrische Größe zur Verfügung zu stellen, die proportional zu einem durch den Shunt fließenden Strom ist, wobei die Verstärkerschaltung eine Kombination von Widerständen aufweist, die einen Verstärkungsfaktor der Verstärkerschaltung bestimmt, wobei die relative Änderung des elektrischen Widerstands des Shunts mit der Temperatur von einem ersten Temperaturkoeffizienten beschrieben wird, wobei mindestens einer der Widerstände der Kombination von Widerständen oder eine Unterkombination der Widerstände der Kombination von Widerständen thermisch mit dem Shunt gekoppelt ist und wobei die relative Änderung des elektrischen Widerstands des mindestens einen Widerstands oder der Unterkombination der Widerstände mit der Temperatur von einem zweiten Temperaturkoeffizienten beschreiben wird, wobei eine über einen Betriebstemperaturbereich gemittelte Abweichung des zweiten Temperaturkoeffizienten von dem ersten Temperaturkoeffizienten höchstens 50 % beträgt.

Das elektrische Versorgungsnetz kann zum Beispiel ein Versorgungsnetz sein, aus dem ein Haushalt oder ein Industrie- oder Gewerbebetrieb mit elektrischer Energie versorgt wird oder in das ein Haushalt oder ein Industrie- oder Gewerbebetrieb elektrische Energie einspeist. Die Strommessvorrichtung dient zur Messung eines dem elektrischen Versorgungsnetz entnommenen oder in das elektrische Versorgungsnetz eingespeisten Stroms. Die Strommessung kann zur Ermittlung einer Energiemenge ausgeführt werden, insbesondere zu Abrechnungszwecken, jedoch auch unabhängig davon oder zusätzlich zum Beispiel zur Überwachung einer Netzqualität.

Die Strommessvorrichtung weist einen Shunt auf, auf Deutsch auch bezeichnet als Nebenschlusswiderstand. Bei dem Shunt handelt es sich um einen niederohmigen elektrischen Widerstand. Der zu messende Strom fließt durch den Shunt. Hierzu kann ein erster Kontakt des Shunts mit einer Leitung des Versorgungsnetzes, insbesondere mit einer Phase, verbunden sein, der andere Kontakt mit einer Leitung, die zu einem oder mehreren elektrischen Verbrauchern oder Energieerzeugern führt. Nach dem Ohm'schen Gesetz entsteht an dem Shunt ein Spannungsabfall, der proportional zu der durch den Shunt fließenden Stromstärke ist. Der elektrische Widerstand des Shunts ist von der Temperatur abhängig. Diese Abhängigkeit wird von dem ersten Temperaturkoeffizienten beschrieben, der die relative Änderung des Widerstands bei einer bestimmten Ausgangstemperatur angibt, zum Beispiel in der Einheit %/K oder ppm/K.

Der Spannungsabfall wird an einem Eingang der Verstärkerschaltung erfasst. Der Eingang kann zwei Kontakte aufweisen, von denen einer mit dem versorgungsnetzseitigen Ende des Shunts, der andere mit dem verbraucher- bzw. erzeugerseitigen Ende des Shunts verbunden ist. Die Verstärkerschaltung stellt an einem Ausgang eine elektrische Größe zur Verfügung, insbesondere eine elektrische Spannung oder eine elektrische Stromstärke, die proportional zu dem Spannungsabfall ist. Vorausgesetzt, der elektrische Widerstand des Shunts weist einen konstanten Wert auf, ist die elektrische Größe damit auch proportional zu dem durch den Shunt fließenden Strom. In der Realität gilt dies nur näherungsweise, insbesondere weil Temperaturabhängigkeiten des elektrischen Widerstands des Shunts und Nichtlinearitäten der Verstärkerschaltung die angestrebte Proportionalität beeinträchtigen können.

Der Spannungsabfall an dem Shunt ist aus den erwähnten Gründen gering und liegt typischerweise in der Größenordnung einiger mV. Die Verstärkerschaltung stellt davon ausgehend eine elektrische Größe zur Verfügung, die für eine digitale Weiterverarbeitung besser geeignet ist und im Falle einer elektrischen Spannung typischerweise in der Größenordnung von einigen V liegt. Die am Ausgang der Verstärkerschaltung bereitgestellte elektrische Größe kann zum Beispiel von einem A/D-Wandler digitalisiert werden. Es versteht sich, dass die genannten Spannungswerte nur beispielhaft sind und je nach Anwendung größere oder kleinere Werte verwendet werden können.

Dementsprechend kann mit Verstärkungsfaktoren aus einem großen Bereich gearbeitet werden. Der Verstärkungsfaktor der Verstärkerschaltung wird von einer Kombination von Widerständen bestimmt. Im einfachsten Fall zum Beispiel von den Quotienten eines Widerstands in einem Rückkopplungspfad und einem eingangsseitigen Widerstand. Der Quotient ist in der Regel bei einem invertierenden Verstärker negativ, bei einem nicht-invertierenden Verstärker positiv.

Bei der Erfindung ist mindestens einer der Widerstände der Kombination von Widerständen oder eine Unterkombination davon thermisch mit dem Shunt gekoppelt. Die thermische Kopplung sorgt dafür, dass der Shunt und der mindestens eine Widerstand bzw. die Unterkombination von Widerständen im Betrieb der Strommessvorrichtung ähnliche Temperaturen, idealerweise dieselbe Temperatur aufweisen. Insbesondere führt eine Erwärmung des Shunts zu einer ungefähr entsprechenden Erwärmung des mindestens einen Widerstands. Die relative Änderung des elektrischen Widerstands des mindestens einen Widerstands oder der Unterkombination der Widerstände mit der Temperatur wird von dem zweiten Temperaturkoeffizienten beschreiben. Bei der Erfindung beträgt die Abweichung des zweiten Temperaturkoeffizienten von dem ersten Temperaturkoeffizienten höchstens 50 %, und zwar gemittelt über einen Betriebstemperaturbereich. Die Abweichung kann auch nur höchsten 30 %, höchstens 20 %, höchstens 10 % oder höchstens 5 % betragen. Mit anderen Worten weisen der Shunt und der mindestens eine Widerstand bzw. die Unterkombination von Widerständen bei der Erfindung also näherungsweise dasselbe Temperaturverhalten auf. Im Idealfall gibt es gar keine Abweichung des zweiten Temperaturkoeffizienten von dem ersten Temperaturkoeffizienten.

Dies führt dazu, dass die relative Änderung des elektrischen Widerstands des Shunts und die relative Änderung des elektrischen Widerstands des mindestens einen Widerstands bzw. der Unterkombination von Widerständen in Abhängigkeit von der Temperatur näherungsweise, idealerweise exakt, gleich groß sind.

Durch das näherungsweise gleiche Temperaturverhalten von Shunt und dem mindestens einen Widerstand bzw. der Unterkombination von Widerständen und deren thermische Kopplung wird bei der Erfindung eine Kompensation der Temperaturabhängigkeit des Shunts durch eine entsprechende Temperaturabhängigkeit des Verstärkungsfaktors erzielt. Dies gelingt ohne die einleitend zum Stand der Technik erläuterte, rechnerische Kompensation des Temperaturverhaltens und ohne eine Messung der Temperatur des Shunts. Dadurch kann bei der Erfindung eine sehr hohe Messgenauigkeit mit relativ geringem Aufwand erzielt werden. Für viele Anwendungen ist es außerdem möglich, einen besonders einfach aufgebauten und kostengünstigen Shunt zu verwenden. Beispielsweise kann statt eines Manganin-Shunts ein einfacher Kupfer-Shunt verwendet werden, weil dessen ungünstigeres Temperaturverhalten automatisch kompensiert wird. Bei Verwendung eines Präzisions-Shunts, beispielsweise aus dem erwähnten Manganin, kann durch die erfindungsgemäße Kompensation des Temperaturverhaltens die Messgenauigkeit noch weiter erhöht werden.

Insbesondere kann der zweite Temperaturkoeffizient so auf den ersten Temperaturkoeffizienten abgestimmt werden, dass die Temperaturabhängigkeit des Verstärkungsfaktors die Temperaturabhängigkeit des Shunts mindestens teilweise kompensiert.

Die Temperaturkoeffizienten aller Widerstände der Kombination von Widerständen, die den Verstärkungsfaktor bestimmen, können so gewählt werden, dass die relative Änderung der am Ausgang zur Verfügung gestellten, elektrischen Größe mit der Temperatur nur halb so groß ist, wie die die relative Änderung des elektrischen Widerstands des Shunts mit der Temperatur, gegebenenfalls wieder betrachtet im Mittel über den Betriebstemperaturbereich.

In einer Ausgestaltung weist einer der Widerstände der Kombination von Widerständen, der nicht der mindestens eine Widerstand ist und der nicht zu der Unterkombination gehört, einen dritten Temperaturkoeffizienten auf, der sich von dem Temperaturkoeffizienten unterscheidet. Dieser Widerstand weist also ein anderes Temperaturverhalten auf. Beispielsweise können für einen oder mehrere der den Verstärkungsfaktor bestimmenden Widerstände herkömmliche Dickschicht-Widerstände, Dünnschicht-Widerstände, Metallschicht-Widerstände oder Draht-Widerstände verwendet werden.

In einer Ausgestaltung schließt der Betriebstemperaturbereich einen Bereich 0° C bis +50° C ein, bevorzugt einen Bereich von -20° C bis + 70° C, besonders bevorzugt einen Bereich von -65° C bis + 175° C. Insbesondere für Spezialanwendungen sind auch größere oder kleinere Betriebstemperaturbereiche möglich.

In einer Ausgestaltung sind der Shunt und der mindestens eine Widerstand oder der Shunt und die Unterkombination von Widerständen unmittelbar benachbart angeordnet und/oder über einen Wärmeleiter miteinander verbunden. Durch beide Maßnahmen wird erreicht, dass sich die Temperaturen von Shunt und dem mindestens einen Widerstand angleichen. Möglich ist zum Beispiel eine Befestigung der beiden Bauteile an einem gemeinsamen Kühlkörper oder Gehäuseelement, wobei auf eine ausreichende elektrische Isolation zwischen den beiden Bauteilen geachtet werden muss.

In einer Ausgestaltung sind ein Kontakt des Shunts und ein Kontakt des mindestens einen Widerstands elektrisch leitend miteinander verbunden. Die elektrisch leitende Verbindung kann durch eine unmittelbare Verbindung der beiden Kontakte erfolgen, beispielsweise durch Löten oder Schweißen. Möglich ist auch eine Verbindung über eine kurze Leiterbahn oder einen kurzes Kabel- oder Leiterstück. Die elektrisch leitende Verbindung führt ebenfalls zu einer guten thermischen Kopplung.

In einer Ausgestaltung fließt der elektrische Widerstand des mindestens einen Widerstands oder der elektrische Widerstand der Unterkombination von Widerständen umgekehrt proportional in den Verstärkungsfaktor ein. Dies führt unmittelbar zu der erwünschten Kompensation. Besteht der Shunt beispielsweise aus einem Widerstandsmaterial, dessen elektrischer Widerstand sich in einem bestimmten Temperaturbereich mit der Temperatur vergrößert, erhöht sich der Spannungsabfall an dem Shunt mit der Temperatur entsprechend. Fließt der elektrische Widerstand des mindestens einen Widerstands umgekehrt proportional in den Verstärkungsfaktor ein, bewirkt die Erhöhung des elektrischen Widerstands des mindestens einen Widerstands mit der Temperatur eine entsprechende Verkleinerung des Verstärkungsfaktors.

In einer Ausgestaltung weisen der Shunt und der mindestens eine Widerstand dasselbe Widerstandsmaterial auf. Mit Widerstandsmaterial ist dasjenige Material des Shunts bzw. des mindestens einen Widerstands gemeint, das für den elektrischen Widerstand des Bauteils maßgeblich ist. Sowohl der Shunt als auch der mindestens eine Widerstand können weitere Elemente aufweisen, insbesondere für das Anschließen des jeweiligen Bauteils dienende Leiterstücke. Diese können aus einem anderen Material bestehen. Als Widerstandsmaterial für den Shunt und für den mindestens einen Widerstand kommen beispielsweise die folgenden Materialien in Betracht: Kupfer, Stahl, Manganin, Konstantan. Da das Widerstandsmaterial für den Shunt in der Regel einen geringen spezifischen Widerstand aufweisen muss, um die Niederohmigkeit des Shunts zu gewährleisten, sind viele gängige Widerstandsmaterialien, die für hochohmige Widerstände eingesetzt werden, beispielsweise Kohleschichtmaterialien, für den Shunt in der Regel ungeeignet. Es ist jedoch möglich, den mindestens einen Widerstand aus demselben Material mit einem geringen spezifischen elektrischen Widerstand herzustellen, wenn das Widerstandsmaterial entsprechend dimensioniert wird. Der besondere Vorteil der Verwendung desselben Widerstandsmaterials für den Shunt und den mindestens einen Widerstand ist, dass die beiden Bauteile automatisch dasselbe Temperaturverhalten aufweisen, d.h. dass der erste Temperaturkoeffizient und der zweite Temperaturkoeffizient praktisch gleich sind.

In einer Ausgestaltung weist der Shunt ein anderes Widerstandsmaterial auf als der mindestens eine Widerstand. Durch eine gezielte Auswahl einer geeigneten Materialkombination kann auch mit unterschiedlichen Widerstandsmaterialien näherungsweise dasselbe Temperaturverhalten erzielt werden. Beispielsweise kann als Widerstandsmaterial für den Shunt eine Kupfer-Mangan-Nickel-Legierung verwendet werden, z.B. Manganin, Noventin, oder Zeranin (Kupfer-Mangan-Nickel-Silizium), oder eine Nickel-Chrom-Aluminium-Legierung wie ISAOHM (Nickel-Chrom-Aluminium-Silizium). Diese Legierungen haben einen Temperaturverlauf, bei dem bei hohen und bei niedrigen Temperaturen der Widerstandswert sinkt. Für das Widerstandsmaterial des mindestens einen Widerstands kann beispielsweise Konstantan verwendet werden, Isotan oder Resistherm (eine Nickel-Eisen-Legierung).

In einer Ausgestaltung weist die Unterkombination von Widerständen eine Kombination eines ersten Widerstands und eines Ausgleichswiderstands auf, wobei der erste Widerstand ein von dem Shunt abweichendes Temperaturverhalten aufweist und der Ausgleichswiderstand das Temperaturverhalten der Unterkombination von Widerständen an das Temperaturverhalten des Shunts angleicht. Auf diese Weise wird insgesamt dasselbe Temperaturverhalten der Unterkombination von Widerständen einerseits und des Shunts andererseits erzielt.

In einer Ausgestaltung weist der mindestens eine Widerstand oder die Unterkombination von Widerständen eine Spule auf. Beispielsweise kann für den Shunt ein Stanzteil aus Kupfer und für den mindestens einen Widerstand bzw. für die Unterkombination von Widerständen eine Spule aus einem Kupferdraht verwendet werden. Durch die Verwendung einer Spule kann aus einem Widerstandsmaterial mit einem für den Shunt vorteilhaften, niedrigen spezifischen elektrischen Widerstand ein vergleichsweise hochohmiger Widerstand für die Verstärkerschaltung hergestellt werden. Die Spule kann insbesondere in einem industriell gefertigten Gehäuse angeordnet sein.

In einer Ausgestaltung weist die Verstärkerschaltung einen Rückkopplungspfad auf, in dem ein Korrekturfilter angeordnet ist, der ein durch die Spule verursachtes Tiefpassverhalten kompensiert. Die Verwendung einer Spule für den mindestens einen Widerstand führt aufgrund der Induktivität der Spule zu einer Frequenzabhängigkeit des Stroms und damit zu einem tiefpassartigen Verhalten und einer entsprechenden Frequenzabhängigkeit des Verstärkungsfaktors. Dieser Effekt wird durch den Korrekturfilter in dem Rückkopplungspfad kompensiert.

In einer Ausgestaltung ist der Shunt eine Leiterbahn auf einer Leiterplatte. Für eine ausreichende Stromtragfähigkeit kann die Leiterbahn eine relativ große Breite und/oder eine relativ große Dicke aufweisen. Die Verwendung einer Leiterbahn vereinfacht die elektrische Verbindung des Shunts insbesondere mit dem Eingang der Verstärkerschaltung. Auch sonstige Anschlüsse an das Stromversorgungsnetz und eine verbraucherseitige Leitung können durch entsprechende, in die Leiterplatte integrierte Anschlüsse einfach hergestellt werden.

In einer Ausgestaltung ist der mindestens eine Widerstand eine Leiterbahn auf einer Leiterplatte. Dies ermöglicht eine einfache Herstellung des mindestens einen Widerstands. Von besonderem Vorteil ist, wenn für den Shunt und den mindestens einen Widerstand dieselbe Leiterplatte verwendet wird. In diesem Fall vereinfacht sich die Herstellung und die gewünschte thermische Kopplung entsteht ganz oder teilweise durch die benachbarte Anordnung der beiden Leiterbahnen auf der Leiterplatte.

In einer Ausgestaltung ist die Verstärkerschaltung ein invertierender Verstärker, ein nicht invertierender Verstärker oder ein Differenzverstärker. Die Verstärkerschaltung kann insbesondere mit einem Operationsverstärker aufgebaut sein, der entsprechend beschaltet ist. Zum Beispiel kann der mindestens eine Widerstand bei einem invertierenden Verstärker zwischen einen Kontakt des Shunts und den invertierenden Eingang eines Operationsverstärkers geschaltet sein. Bei einer Beschaltung als Differenzverstärker kann der invertierende Eingang des Operationsverstärkers über einen ersten Widerstand mit einem ersten Kontakt des Shunts verbunden werden und der nicht-invertierende Eingang des Operationsverstärkers über einen zweiten Widerstand mit einem zweiten Kontakt des Shunts. In diesem Fall bilden der erste Widerstand und der zweite Widerstand eine Unterkombination von Widerständen, die thermisch mit dem Shunt gekoppelt wird. Weitere Beispiele werden im Zusammenhang mit den Ausführungsbeispielen erläutert.

In einer Ausgestaltung ist die Strommessvorrichtung ein Elektrizitätszähler. Der Elektrizitätszähler kann zur Erfassung eines Energieverbrauchs bestimmt sein, insbesondere zu Abrechnungszwecken. Es kann sich um ein Haushaltselektrizitätszähler oder um einen Elektrizitätszähler für gewerbliche oder industrielle Anwendung handeln. Der Elektrizitätszähler kann insbesondere einphasig oder dreiphasig sein. Nachfolgend wird die Erfindung anhand von in Figuren dargestellten Ausführungsbeispielen näher erläutert. Es zeigen:
- Fig. 1: eine Strommessvorrichtung mit einer invertierenden Verstärkerschaltung,
- Fig. 2: eine Strommessvorrichtung mit einer Spule,
- Fig. 3: eine Strommessvorrichtung mit zwei Ausgleichswiderständen,
- Fig. 4: eine andere Strommessvorrichtung mit mehreren Ausgleichswiderständen,
- Fig. 5: eine Strommessvorrichtung mit einer nicht invertierenden Verstärkerschaltung,
- Fig. 6: eine Strommessvorrichtung mit einem Differenzverstärker,
- Fig. 7: ein Diagramm zum Temperaturkoeffizienten von Manganin,
- Fig. 8: ein Diagramm zum Temperaturkoeffizienten von Isotan.

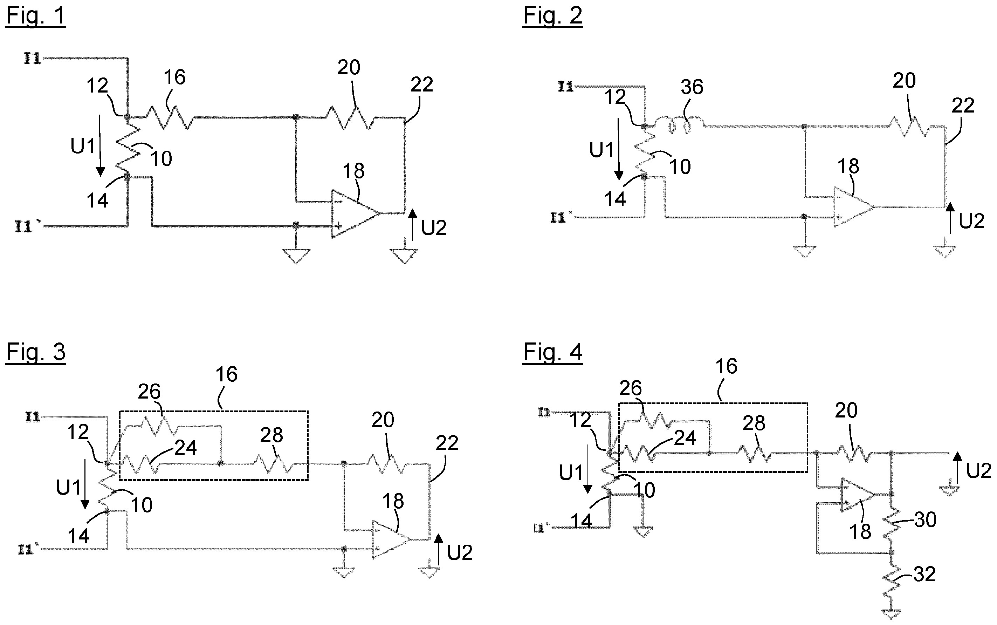

Die Fign. 1 bis 6 zeigen jeweils eine Strommessvorrichtung in einem vereinfachten Schaltplan, beispielhaft zur Messung eines elektrischen Stroms einer Phase eines elektrischen Versorgungsnetzes. Ein versorgungsnetzseitiger Anschluss dieser Phase ist mit I1 bezeichnet. Er ist mit einem ersten Kontakt 12 eines Shunts 10 verbunden.

Ein verbraucherseitiger Anschluss der Phase ist mit I1' bezeichnet. Er ist mit einem zweiten Kontakt 14 des Shunts 10 verbunden. Fließt ein Strom vom Anschluss I1 zum Anschluss I1' durch den Shunt, verursacht dies einen Spannungsabfall U1 an dem Shunt 10. Es versteht sich, dass die Anschlüsse I1/I1' auch am Sekundärkreis eines Stromwandlers angeordnet sein können. In diesem Fall fließt der zu messende Strom ebenfalls durch den Shunt 10, entspricht jedoch nicht 1:1 dem im Primärkreis fließenden Strom, dessen Größe eigentlich von Interesse ist.

Im Ausführungsbeispiel der Fig. 1 wird dieser Spannungsabfall U1 über einen Widerstand 16 an den invertierenden Eingang eines Operationsverstärkers 18 geführt. Der Widerstand 16 ist thermisch mit dem Shunt 10 gekoppelt. Der Ausgang des Operationsverstärkers ist über einen weiteren Widerstand 20 in einem Rückkopplungspfad 22 an den invertierenden Eingang zurückgeführt. Am Ausgang des Operationsverstärkers 18 stellt die Verstärkerschaltung eine invertierte Ausgangsspannung U2 zur Verfügung, die proportional zur Spannung U1 ist. Das Verhältnis des weiteren Widerstands 20 zu dem Widerstand 16 bestimmt den Verstärkungsfaktor U2/U1 der Verstärkerschaltung.

Die Ausgangsspannung U2 ist eine elektrische Größe, die (im Idealfall) proportional zu dem durch den Shunt 10 fließenden Strom ist. Der nicht invertierende Eingang des Operationsverstärkers 18 ist mit Masse verbunden, ebenso der zweite Kontakt 14 des Shunts 10.

Die Temperaturkompensation der Strommessvorrichtung aus Figur 1 soll anhand eines Zahlenbeispiels erläutert werden. Angenommen, der Shunt 10 weist als Widerstandsmaterial Kupfer auf und hat bei einer Temperatur von 23 °C einen elektrischen Widerstand von 100 µΩ und bei einer Temperatur von 70 °C einen elektrischen Widerstand von 120 µΩ. Bei einem als konstant angenommenen Stromfluss von 100 A durch den Shunt 10 entsteht am Shunt bei 23 °C ein Spannungsabfall von 10 mV. Bei 70 °C sind es wegen des erhöhten Widerstands des Shunts 12 mV.

Der Widerstand 16 weist bei 23 °C einen elektrischen Widerstand von 10 Ω und bei 70 °C von 12 Ω auf. Der im Rückkopplungspfad 22 angeordnete, weitere Widerstand 20 weist einen als temperaturunabhängig angenommen elektrischen Widerstand von 1 kΩ auf.

Der Operationsverstärker 18 stellt an seinem Ausgang eine Spannung U2 ein, die die am invertierenden Eingang anliegende Spannung auf das am nicht-invertierenden Eingang anliegende Massepotential bringt. Dies ist der Fall, wenn der Spannungsabfall an dem Widerstand 16 genauso groß ist wie der Spannungsabfall U1 an dem Shunt 10. Dies erfordert bei 23 °C einen Strom von 1 mA durch den Widerstand 16. Diese Stromstärke muss auch durch den Rückkopplungspfad 22 fließen. Dies ist der Fall, wenn die Ausgangsspannung U2 1 V beträgt.

Bei 70 °C beträgt der Spannungsabfall U1 am Shunt 10 12 mV. Da sich der Widerstand 16 bei 70° wegen der Verwendung desselben Widerstandsmaterials in derselben Weise verändert hat, wie der elektrische Widerstand des Shunts 10, beträgt der elektrische Widerstand des Widerstands 16 nunmehr 12 Ω. Damit über den Widerstand 16 dieselbe Spannung abfällt, wie über den Shunt 10, muss immer noch ein Strom von 1 mA durch den Widerstand 16 fließen. Es bleibt daher bei der Ausgangsspannung der Verstärkerschaltung am Ausgang des Operationsverstärkers 18 von 1 V. Die Ausgangsspannung U2 der Verstärkerschaltung ist daher unabhängig von der temperaturbedingten Änderung des elektrischen Widerstands des Shunts 10.

Die Strommessvorrichtung aus Fig. 2 unterscheidet sich von derjenigen aus Fig. 1 nur durch die Verwendung einer Kupferspule 36 für den mindestens einen Widerstand 16.

Figur 3 zeigt eine andere Strommessvorrichtung, bei der der mindestens eine Widerstand 16, der zwischen den ersten Kontakt 12 des Shunts 10 und den invertierenden Eingang des Operationsverstärkers 18 geschaltet ist, eine Unterkombination von drei Widerständen ist. Die Unterkombination weist einen ersten Widerstand 24 und zwei Ausgleichswiderstände 26, 28 auf. Diese Widerstände bestehen aus unterschiedlichen Materialien und sind so dimensioniert, dass die Unterkombination insgesamt dasselbe Temperaturverhalten aufweist wie der Shunt 10.

Figur 4 zeigt ein weiteres Beispiel, bei dem der invertierende Eingang des Operationsverstärkers 18 in derselben Weise beschaltet ist, wie in der Fig. 3. Der Ausgang des Operationsverstärkers 18 ist jedoch über einen Spannungsteiler mit Masse verbunden und die geteilte Ausgangsspannung ist an den nicht-invertierenden Eingang des Operationsverstärkers 18 zurückgeführt. Der Spannungsteiler weist zwei (weitere) Ausgleichswiderstände 30, 32 auf, die Teil der Unterkombination von Widerständen sind. Auch diese Unterkombination von nunmehr fünf Widerständen 24, 26, 28, 30, 32 ist so dimensioniert, dass das Temperaturverhalten des Verstärkungsfaktors dasselbe ist, wie das Temperaturverhalten des Shunts 10.

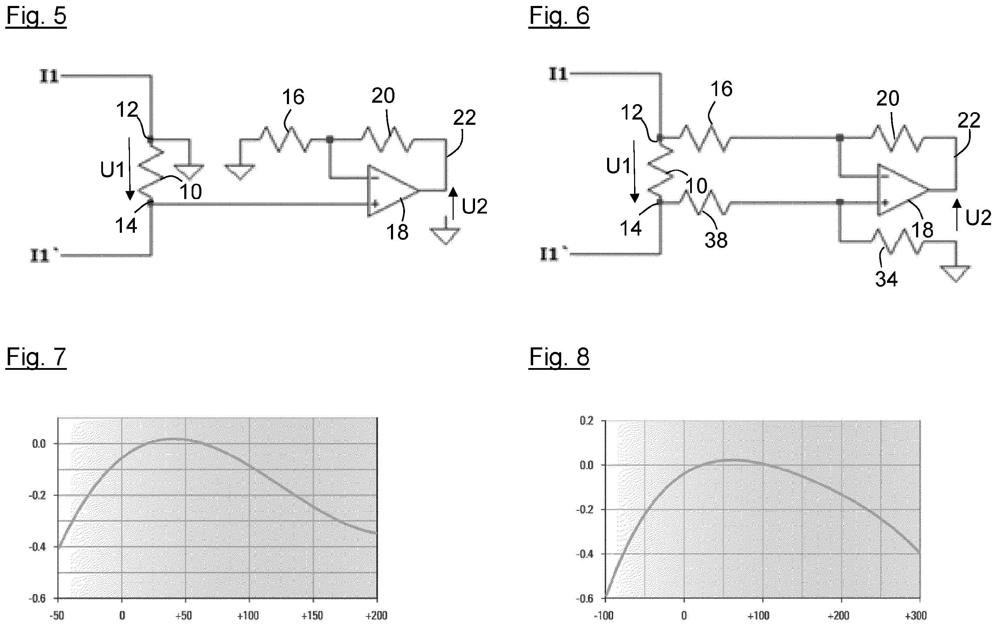

Figur 5 zeigt eine Strommessvorrichtung mit einer Verstärkerschaltung, die als nichtinvertierender Verstärker beschaltet ist. Hierzu ist der erste Kontakt 12 des Shunts 10 mit Masse verbunden. Der zweite Kontakt 14 des Shunts 10 ist mit dem nicht-invertierenden Eingang des Operationsverstärkers 18 verbunden. Der invertierende Eingang des Operationsverstärkers 18 ist über den Widerstand 16 mit Masse verbunden. Im Rückkopplungspfad 22 zwischen Ausgang und invertierendem Eingang des Operationsverstärkers 18 ist wie zuvor ein Widerstand 20 angeordnet. Auch in diesem Beispiel wird der Verstärkungsfaktor der Verstärkerschaltung durch die beiden Widerstände 16, 20 bestimmt. Der vom invertierenden Eingang des Operationsverstärkers 18 nach Masse geführte Widerstand 16 weist dasselbe Temperaturverhalten auf wie der Shunt 10 und ist thermisch mit diesem gekoppelt.

Im Ausführungsbeispiel der Fig. 6 ist der Operationsverstärker 18 als Differenzverstärker beschaltet. Hierzu ist der invertierende Eingang des Operationsverstärkers 18 über den Widerstand 16 mit dem ersten Kontakt 12 des Shunts 10 verbunden und der nicht-invertierende Eingang des Operationsverstärkers 18 über einen Widerstand 38 mit dem zweiten Kontakt 14 des Shunts 10. Der nicht-invertierende Eingang des Operationsverstärkers 18 ist außerdem über einen weiteren Widerstand 34 mit Masse verbunden. Im Rückkopplungspfad 22 zwischen Ausgang und invertierendem Eingang des Operationsverstärkers ist wie zuvor ein weiterer Widerstand 20 angeordnet.

Figur 7 zeigt ein Diagramm zur relativen Änderung in %/K des elektrischen Widerstands eines Shunts mit dem Widerstandsmaterial Manganin. Man erkennt ein Maximum des Temperaturkoeffizienten von etwa 0,025 %/K bei einer Temperatur von etwa 40 °C. Bei geringeren Temperaturen fällt der Temperaturkoeffizient ab, bei einer Temperatur von -50 °C erreicht er einen Wert von etwa -0,4 %/K. Zu höheren Temperaturen hin nimmt der Temperaturkoeffizient ebenfalls ab. Bei einer Temperatur von 200 °C weist er einen Wert von etwa -0,35 %/K auf.

Figur 8 zeigt ein Diagramm zum Temperaturkoeffizienten des Widerstandsmaterials Isotan. Dieses Material weist qualitativ einen ähnlichen Verlauf auf, wie das Manganin aus Fig. 7. Das Maximum liegt jedoch bei einer etwas höheren Temperatur von ca. 70 °C bei einem Wert von 0,02 %/K. Wird für den Shunt das Widerstandsmaterial Manganin und für den mindestens einen Widerstand das Widerstandsmaterial Isotan verwendet, ergibt sich bei thermischer Kopplung somit im Wesentlichen dasselbe Temperaturverhalten.

Durch Ergänzen von einem oder mehreren Ausgleichswiderständen, beispielsweise wie in den Schaltbildern der Figuren 3 und 4 gezeigt, kann das Temperaturverhalten weiter an das Temperaturverhalten des Shunts angeglichen werden, sodass die Temperaturkompensation optimiert werden kann.

### Liste der Bezugszeichen

- 10: Shunt
- 12: erster Kontakt
- 14: zweiter Kontakt
- 16: Widerstand
- 18: Operationsverstärker
- 20: Widerstand
- 22: Rückkopplungspfad
- 24: Widerstand
- 26: Ausgleichswiderstand
- 28: Ausgleichswiderstand
- 30: Ausgleichswiderstand
- 32: Ausgleichswiderstand
- 34: Widerstand
- 36: Spule
- 38: Widerstand
- U1: Spannungsabfall
- U2: Ausgangsspannung

## Patentansprüche

1. Strommessvorrichtung für ein elektrisches Versorgungsnetz, wobei die Strommessvorrichtung einen Shunt (10) und eine Verstärkerschaltung aufweist, die dazu eingerichtet ist, einen Spannungsabfall (U1) an dem Shunt (10) zu erfassen und an einem Ausgang eine elektrische Größe zur Verfügung zu stellen, die proportional zu einem durch den Shunt (10) fließenden Strom ist, wobei die Verstärkerschaltung eine Kombination von Widerständen (16, 20) aufweist, die einen Verstärkungsfaktor der Verstärkerschaltung bestimmt, wobei die relative Änderung des elektrischen Widerstands des Shunts mit der Temperatur von einem ersten Temperaturkoeffizienten beschrieben wird, **dadurch gekennzeichnet, dass** mindestens einer der Widerstände (16) der Kombination von Widerständen oder eine Unterkombination der Widerstände der Kombination von Widerständen thermisch mit dem Shunt (10) gekoppelt ist, wobei die relative Änderung des elektrischen Widerstands des mindestens einen Widerstands (16) oder der Unterkombination der Widerstände mit der Temperatur von einem zweiten Temperaturkoeffizienten beschrieben wird, wobei eine über einen Betriebstemperaturbereich gemittelte Abweichung des zweiten Temperaturkoeffizienten von dem ersten Temperaturkoeffizienten höchstens 50 % beträgt.

2. Strommessvorrichtung nach Anspruch 1, **dadurch gekennzeichnet, dass** einer der Widerstände der Kombination von Widerständen, der nicht der mindestens eine Widerstand ist und der nicht zu der Unterkombination gehört, einen dritten Temperaturkoeffizienten aufweist, der sich von dem zweiten Temperaturkoeffizienten unterscheidet.

3. Strommessvorrichtung nach Anspruch 1 oder 2, **dadurch gekennzeichnet, dass** der Betriebstemperaturbereich einen Bereich 0° C bis +50° C einschließt, bevorzugt einen Bereich von -20° C bis + 70° C, besonders bevorzugt einen Bereich von -65° C bis + 175° C.

4. Strommessvorrichtung nach einem der Ansprüche 1 bis 3, **dadurch gekennzeichnet, dass** der Shunt (10) und der mindestens eine Widerstand (16) oder der Shunt (10) und die Unterkombination von Widerständen unmittelbar benachbart angeordnet und/oder über einen Wärmeleiter miteinander verbunden sind.

5. Strommessvorrichtung nach einem der Ansprüche 1 bis 4, **dadurch gekennzeichnet, dass** ein Kontakt des Shunts (10) und ein Kontakt des mindestens einen Widerstands elektrisch leitend miteinander verbunden sind.

6. Strommessvorrichtung nach einem der Ansprüche 1 bis 5, **dadurch gekennzeichnet, dass** der elektrische Widerstand des mindestens einen Widerstands oder der elektrische Widerstand der Unterkombination von Widerständen umgekehrt proportional in den Verstärkungsfaktor einfließt.

7. Strommessvorrichtung nach einem der Ansprüche 1 bis 6, **dadurch gekennzeichnet, dass** der Shunt (10) und der mindestens eine Widerstand (16) dasselbe Widerstandsmaterial aufweisen.

8. Strommessvorrichtung nach einem der Ansprüche 1 bis 6, **dadurch gekennzeichnet, dass** der Shunt (10) ein anderes Widerstandsmaterial aufweist als der mindestens eine Widerstand (16).

9. Strommessvorrichtung nach einem der Ansprüche 1 bis 8, **dadurch gekennzeichnet, dass** die Unterkombination von Widerständen eine Kombination eines ersten Widerstands (24) und eines Ausgleichswiderstands (26, 28) aufweist, wobei der erste Widerstand (24) ein von dem Shunt (10) abweichendes Temperaturverhalten aufweist und der Ausgleichswiderstand (26, 28) das Temperaturverhalten der Unterkombination von Widerständen an das Temperaturverhalten des Shunts (10) angleicht.

10. Strommessvorrichtung nach einem der Ansprüche 1 bis 9, **dadurch gekennzeichnet, dass** der mindestens eine Widerstand oder die Unterkombination von Widerständen eine Spule (36) aufweist.

11. Strommessvorrichtung nach Anspruch 10, **dadurch gekennzeichnet, dass** die Verstärkerschaltung einen Rückkopplungspfad (22) aufweist, in dem ein Korrekturfilter angeordnet ist, der ein durch die Spule (36) verursachtes Tiefpassverhalten kompensiert.

12. Strommessvorrichtung nach einem der Ansprüche 1 bis 11, **dadurch gekennzeichnet, dass** der Shunt (10) eine Leiterbahn auf einer Leiterplatte ist.

13. Strommessvorrichtung nach einem der Ansprüche 1 bis 12, **dadurch gekennzeichnet, dass** der mindestens eine Widerstand eine Leiterbahn auf einer Leiterplatte ist.

14. Strommessvorrichtung nach einem der Ansprüche 1 bis 13, **dadurch gekennzeichnet, dass** die Verstärkerschaltung ein invertierender Verstärker, ein nichtinvertierender Verstärker oder ein Differenzverstärker ist.

15. Strommessvorrichtung nach einem der Ansprüche 1 bis 14, **dadurch gekennzeichnet, dass** die Strommessvorrichtung ein Elektrizitätszähler ist.

## Geänderte Patentansprüche

### Geänderte Patentansprüche gemäss Regel 137(2) EPÜ.

1. Strommessvorrichtung für ein elektrisches Versorgungsnetz, wobei die Strommessvorrichtung einen Shunt (10) und eine Verstärkerschaltung aufweist, die dazu eingerichtet ist, einen Spannungsabfall (U1) an dem Shunt (10) zu erfassen und an einem Ausgang eine elektrische Größe zur Verfügung zu stellen, die proportional zu einem durch den Shunt (10) fließenden Strom ist, wobei die Verstärkerschaltung eine Kombination von Widerständen (16, 20) aufweist, die einen Verstärkungsfaktor der Verstärkerschaltung bestimmt, wobei die relative Änderung des elektrischen Widerstands des Shunts mit der Temperatur von einem ersten Temperaturkoeffizienten beschrieben wird, wobei mindestens einer der Widerstände (16) der Kombination von Widerständen oder eine Unterkombination der Widerstände der Kombination von Widerständen thermisch mit dem Shunt (10) gekoppelt ist, wobei die relative Änderung des elektrischen Widerstands des mindestens einen Widerstands (16) oder der Unterkombination der Widerstände mit der Temperatur von einem zweiten Temperaturkoeffizienten beschrieben wird, wobei eine über einen Betriebstemperaturbereich gemittelte Abweichung des zweiten Temperaturkoeffizienten von dem ersten Temperaturkoeffizienten höchstens 50 % beträgt, **dadurch gekennzeichnet, dass** der mindestens eine Widerstand oder die Unterkombination von Widerständen eine Spule (36) aufweist.

2. Strommessvorrichtung nach Anspruch 1, **dadurch gekennzeichnet, dass** einer der Widerstände der Kombination von Widerständen, der nicht der mindestens eine Widerstand ist und der nicht zu der Unterkombination gehört, einen dritten Temperaturkoeffizienten aufweist, der sich von dem zweiten Temperaturkoeffizienten unterscheidet.

3. Strommessvorrichtung nach Anspruch 1 oder 2, **dadurch gekennzeichnet, dass** der Betriebstemperaturbereich einen Bereich 0° C bis +50° C einschließt, bevorzugt einen Bereich von -20° C bis + 70° C, besonders bevorzugt einen Bereich von -65° C bis + 175° C.

4. Strommessvorrichtung nach einem der Ansprüche 1 bis 3, **dadurch gekennzeichnet, dass** der Shunt (10) und der mindestens eine Widerstand (16) oder der Shunt (10) und die Unterkombination von Widerständen unmittelbar benachbart angeordnet und/oder über einen Wärmeleiter miteinander verbunden sind.

5. Strommessvorrichtung nach einem der Ansprüche 1 bis 4, **dadurch gekennzeichnet, dass** ein Kontakt des Shunts (10) und ein Kontakt des mindestens einen Widerstands elektrisch leitend miteinander verbunden sind.

6. Strommessvorrichtung nach einem der Ansprüche 1 bis 5, **dadurch gekennzeichnet, dass** der elektrische Widerstand des mindestens einen Widerstands oder der elektrische Widerstand der Unterkombination von Widerständen umgekehrt proportional in den Verstärkungsfaktor einfließt.

7. Strommessvorrichtung nach einem der Ansprüche 1 bis 6, **dadurch gekennzeichnet, dass** der Shunt (10) und der mindestens eine Widerstand (16) dasselbe Widerstandsmaterial aufweisen.

8. Strommessvorrichtung nach einem der Ansprüche 1 bis 6, **dadurch gekennzeichnet, dass** der Shunt (10) ein anderes Widerstandsmaterial aufweist als der mindestens eine Widerstand (16).

9. Strommessvorrichtung nach einem der Ansprüche 1 bis 8, **dadurch gekennzeichnet, dass** die Unterkombination von Widerständen eine Kombination eines ersten Widerstands (24) und eines Ausgleichswiderstands (26, 28) aufweist, wobei der erste Widerstand (24) ein von dem Shunt (10) abweichendes Temperaturverhalten aufweist und der Ausgleichswiderstand (26, 28) das Temperaturverhalten der Unterkombination von Widerständen an das Temperaturverhalten des Shunts (10) angleicht.

10. Strommessvorrichtung nach einem der Ansprüche 1 bis 9, **dadurch gekennzeichnet, dass** die Verstärkerschaltung einen Rückkopplungspfad (22) aufweist, in dem ein Korrekturfilter angeordnet ist, der ein durch die Spule (36) verursachtes Tiefpassverhalten kompensiert.

11. Strommessvorrichtung nach einem der Ansprüche 1 bis 10, **dadurch gekennzeichnet, dass** der Shunt (10) eine Leiterbahn auf einer Leiterplatte ist.

12. Strommessvorrichtung nach einem der Ansprüche 1 bis 11, **dadurch gekennzeichnet, dass** die Verstärkerschaltung ein invertierender Verstärker, ein nichtinvertierender Verstärker oder ein Differenzverstärker ist.

13. Strommessvorrichtung nach einem der Ansprüche 1 bis 12, **dadurch gekennzeichnet, dass** die Strommessvorrichtung ein Elektrizitätszähler ist.

14. Strommessvorrichtung nach einem der Ansprüche 1 bis 13, **dadurch gekennzeichnet, dass** die Verstärkerschaltung einen Eingang mit einem ersten Kontakt, der mit einem versorgungsnetzseitigen Ende des Shunts verbunden ist, und mit einem zweiten Kontakt, der mit einem verbraucher- bzw. erzeugerseitigen Ende des Shunts verbunden ist, aufweist.
